# EUROPÄISCHE PATENTSCHRIFT

(11) **EP 1 944 335 B1**
(45) Veröffentlichungstag und Bekanntmachung des Hinweises auf die Patenterteilung: **14.03.2012**
(21) Anmeldenummer: 08000134.0
(22) Anmeldetag: 05.01.2008
(51) Int. Cl.: C08K 5/00, C08K 5/5313, C08K 13/02, C08L 63/10, H05K 3/28

(54) **Flammwidrige Harzformulierung und ihre Verwendung**
Flame retardant resin compositions and use thereof
Compositions de résine ininflammables et leur utilisation

(30) Priorität: 12.01.2007 DE 102007001862
(43) Veröffentlichungstag der Anmeldung: 16.07.2008
(73) Patentinhaber: Clariant Finance (BVI) Limited, Road Town, Tortola (VG)
(72) Erfinder: Dietz, Mathias, Dr., 52353 Düren (DE); Bauer, Harald, Dr., 50170 Kerpen (DE); Krause, Werner, Dr., 50354 Hürth (DE)
(74) Vertreter: Jacobi, Carola

(56) Entgegenhaltungen:
- WO-A1-2006/109890
- JP-A- 11 288 090
- US-A1- 2005 234 173
- US-A1- 2006 234 045

## Beschreibung

Die Erfindung betrifft eine neue flammwidrige Harzformulierung und ihre Verwendung.

Bei der Herstellung von gedruckten Schaltungen werden die Leiterzüge zum Schutz von äußeren Einflüssen mit einer dünnen Isolations- und Schutzschicht versehen. Diese Schichten dienen beim späteren Lötverfahren als Lötstoppmasken, da sie den unerwünschten Kontakt mit dem Lot verhindern.

Lötstopplacke lassen sich allgemein in zwei Gruppen unterteilen, die sich durch das Auftragsverfahren charakterisieren lassen. Die Applikation erfolgt üblicherweise entweder im Siebdruck oder durch fototechnische Prozesse. Bei konventionellen Siebdrucklacken wird das Leiterbild durch den Druck mit einer Siebschablone erstellt. Bei fotostrukturierbaren Lötstopplacken wird dagegen die Leiterplatte z. B. im Vorhanggießverfahren oder anderen gängigen Sprühverfahren zunächst flächig beschichtet. Das Leiterbild wird später in einem Belichtungs- und Entwicklungsprozess erzeugt.

Daneben unterscheiden sich Lötstopplacke auch in ihrer Zusammensetzung und dem verwendeten Harzsystem. Zu den verschiedenen Typen an Lötstopplacken gehören u. a.:
- UV-härtende Lötstopplacke
- thermisch härtende Lötstopplacke
- fotostrukturierbare Lötstopplacke
- Lötstopplacke für flexible Schaltungen

Lötstopplacke werden extremen Bedingungen ausgesetzt und müssen daher folgendes Eigenschaftsbild aufweisen:
- gute Lötbadbeständigkeit
- sehr gute Haftfestigkeit
- sehr gute Lösungsmittel-/Reinigungsmittelbeständigkeit
- Feuchtebeständigkeit und hoher Isolationswiderstand
- Nichtbrennbarkeit

Konventionelle Methoden, einen Lotstopplack flammwidrig auszurüsten, ist die Verwendung halogenierter Flammschutzmittel. Dazu gehören z. B. bromierte Epoxidharze. Ein gängiges zur Flammschutzausrüstung von Epoxidharzen verwendetes Flammschutzmittel ist das Tetrabrombisphenol A. Dieses kann direkt in das Epoxidharz eingebaut werden. Als zusätzliches Flammschutzhilfsmittel wird außerdem Antimontrioxid verwendet.

Für lichtempfindliche Lötstopplacke können z. B. bromhaltige Methacrylate wie z. B. 2,4,6-Tribromphenolmethacrylat, Tetrabrombisphenol A Monomethacrylat und Tetrabromobisphenol A Dimethacrylat als Flammschutzmittel eingesetzt werden.

Bromierte Flammschutzmittel haben allerdings den Nachteil, dass sie die Flexibilität beeinträchtigen. Zudem stehen einige Verbindungen unter Verdacht, bei der Verbrennung krebserzeugende Dioxine zu bilden.

Antimontrioxid katalysiert sogar die Bildung von Dioxinen. Antimontrioxid-Stäube können außerdem über die Atemwege aufgenommen werden. Tierversuche haben eindeutig erwiesen, dass diese Stäube krebserregend sind. Daneben sind sowohl die Herstellung als auch die Entsorgung mit Gesundheitsgefahren für die dort Beschäftigten verbunden. In der Müllverbrennung können Antimontrioxid-Stäube über den Schlot in die Umwelt gelangen.

Entsprechend der generell zunehmenden Forderung nach umweltfreundlichen und entsorgungsfreundlichen Materialien werden daher Alternativen vor allem zu den bromierten Flammschutzmitteln gesucht. Diese müssen bromfrei bzw. halogenfrei sein, um solchen Anforderungen zu genügen.

Als Alternative wurden auch Phosphorsäureester untersucht. Die Flammschutzwirkung ist aber sehr gering und es ist daher rel. große Mengen an Phosphorsäureester notwendig, um einen Flammschutzeffekt zu erzielen. Die hohe Dosierung an Phosphorsäureester führt nachteilig zu Ausblühungen an der Oberfläche des ausgehärteten Films.

Andere Alternativen zeigten schlechte Löslichkeiten in den üblicherweise eingesetzten organischen Lösungsmitteln oder waren im Pressure Cooker Test (PCT) nicht beständig (WO2006/106892). Es besteht deshalb der Bedarf, die bisher bekannten flammgeschützten Lötstopplacke hinsichtlich ihrer Eigenschaften zu verbessern.

Es ist deshalb Aufgabe der vorliegenden Erfindung, einen Lötstopplack zur Verfügung zu stellen, der neben einer sehr guten Flammwidrigkeit und Flexibilität auch eine hohe Lötbad- und Feuchtebeständigkeit sowie Temperaturstabilität aufweist.

Gegenstand der vorliegenden Erfindung ist daher eine flammwidrige Harzformulierung, enthaltend jeweils mindestens eine Flammschutzkomponente, eine alkalilösliche Komponente, ein polymerisierbares Monomer, einen Photoiniator und eine Epoxy-Komponente, dadurch gekennzeichnet, dass sie als Flammschutzkomponente ein Phosphinsäuresalz der Formel (I) enthält, 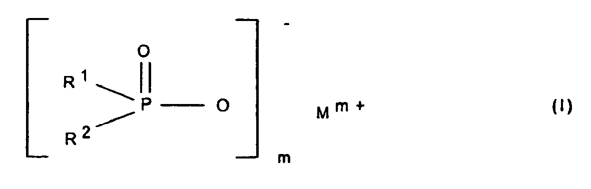 worin
- R¹,: R² gleich oder verschieden sind und unabhängig voneinander C₁-C₆-Alkyl, linear oder verzweigt und/oder Aryl;
- M: Mg, Ca, Al, Sb, Sn, Ge, Ti, Zn, Fe, Zr, Ce, Bi, Sr, Mn, Li, Na, K und/oder eine protonierte Stickstoffbase und m 1 bis 4 bedeuten.

Bevorzugt sind R¹, R² gleich oder verschieden sind und bedeuten, jeweils unabhängig voneinander, Methyl, Ethyl, n-Propyl, iso-Propyl, n-Butyl, tert.-Butyl, n-Pentyl und/oder Phenyl.

Bevorzugt handelt es sich bei dem Phosphinsäuresalz der Formel (I) um das Aluminiumsalz der Diethylphosphinsäure.

Bevorzugt weist das Aluminiumsalz der Diethylphosphinsäure eine mittlere Teilchengröße (d₅₀) von 0,1 bis 100 µm, bevorzugt von 1 bis 20 µm, auf.

Bevorzugt handelt es sich bei der alkalilösliche Komponente um ein modifiziertes Epoxyacrylat.

Bevorzugt handelt es sich bei dem polymerisierbaren Monomeren um mehrwertige Acrylate von mehrwertigen Alkoholen.

Bevorzugt handelt bei den mehrwertigen Alkoholen um Pentaerythrit und/oder Dipentaerythrit.

Bevorzugt handelt es sich bei dem Photoinitiator um alpha-Aminoacetophenone.

Bevorzugt handelt sich dabei um(4-Methylthiobenzoyl)-1-methyl-1-morpholinoethan.

Bevorzugt handelt es sich bei der Epoxyverbindung um einen epoxidierten Novolak.

Bevorzugt enthält die flammwidrige Harzformulierung indestens
0,1 bis 50 Gew.-% Flammschutzkomponente,
0,1 bis 65 Gew.-% alkalilösliche Komponente,
0,1 bis 65 Gew.-% polymerisierbares Monomer,
0,1 bis 15 Gew.-% Photoiniator und
0,1 bis 25 Gew.-% Epoxy-Komponente.

Besonders bevorzugt enthält die flammwidrige Harzformulierung mindestens
5 bis 20 Gew.-% Flammschutzkomponente,
30 bis 40 Gew.-% alkalilösliche Komponente,
5 bis 10 Gew.-% polymerisierbares Monomer,
4 bis 5 Gew.-% Photoiniator und
5 bis 10 Gew.-% Epoxy-Komponente.
Bevorzugt enthält die flammwidrige Harzformulierung weiterhin 0,1 bis 30 Gew.-%, besonders bevorzugt 1 bis 20 Gew.-%, mindestens einer synergistischen Flammschutzkomponente, bei der es sich um Melamin, Melaminderivate der Cyanursäure, Melaminderivate der Isocyanursäure, Melaminsalze wie Melaminphosphat, Melaminpolyphosphat oder Melamindiphosphat, Dicyandiamid oder eine Guanidinverbindung wie Guanidincarbonat, Guanidinphosphat, Guanidinsulfat und/oder um Kondensationsprodukte von Ethylenharnstoff und Formaldehyd oder Ammoniumpolyphosphat; um Sauerstoffverbindungen des Siliciums, wobei es sich dabei um Orthokieselsäure und deren Kondensationsprodukte, um Silikate, Zeolithe und Kieselsäuren; oder um Aluminiumhydroxid handelt.

Die Erfindung betrifft auch die Verwendung der flammwidrigen Harzformulierung nach einem oder mehreren der Ansprüche 1 bis 14 in oder zur Herstellung von Beschichtungen für die Elektronik und Elektrotechnik.

Die Erfindung betrifft insbesondere auch die Verwendung der flammwidrigen Harzformulierung nach einem oder mehreren der Ansprüche 1 bis 14 als Lötstopplack.

Die Erfindung betrifft ebenfalls ein Verfahren zur Herstellung flammgeschützter Lötstopplacke, dadurch gekennzeichnet, dass eine dünne Schicht eines Lötstopplackes durch Schleudern, Tauchen, Rakelbeschichtung, Vorhanggießverfahren, Aufpinseln, Sprühen oder Reverse-Roll-Beschichtung auf ein Substrat aufgebracht, danach getrocknet, belichtet, mit einer alkalischen Lösung entwickelt und nachfolgend thermisch nachgehärtet wird.

Bevorzugt handelt es sich bei dem Substrat um eine starre oder flexible Leiterplatte.

Bevorzugt handelt es sich bei den flexiblen Leiterplatten um unkaschierte oder kupferkaschierte Kunststofffolien auf Basis von Polyester, Polyimid, mit Aramidfasern verstärktes Epoxidharz oder Liquid Crystal Polymer (LCP).

Bevorzugt beträgt die Schichtdicke des Lötstopplackes 0,1 - 50 µm.

Salze von Phosphinsäuren in Kombination mit einer Reihe synergistisch wirkender Verbindungen haben sich als effektive Flammschutzmittel für u. a. Epoxidharze erwiesen (EP-A-1 024 168). Hier wurde ein Epoxidharz aus Bisphenol A und Epichlorhydrin durch Zusatz von Aluminiumtrihydrat und Aluminiumdiethylphosphinat modifiziert, so dass eine UL 94 V0 Einstufung erreicht werden konnte.

Die mit dem Phosphinsäuresalz flammgeschützten Lötstopplacke haben ein gute Lötbadbeständigkeit, haften gut auf allen in der Leiterplattenindustrie üblichen Untergründen, insbesondere auf Kupfer, Blei/Zinn, Zinn-Silber-Kupferlegierungen sowie auf epoxid- und phenolharzgebunden Leiterplatten. Des Weiteren haben die Lötstopplacke eine hohe Flexibilität, wodurch sie auch für die Anwendung in einer flexiblen Leiterplatte geeignet sind.

Bevorzugt bedeutet M Aluminium, Calcium, Titan, Zink, Zinn oder Zirkonium.

Bevorzugte Dialkylphosphinsäuresalze für die erfindungsgemäße flammwidrige Harzformulierung sind Aluminiumtrisdiethylphosphinat, Aluminiumtrismethylethylphosphinat, Titanylbisdiethylphosphinat, Titantetrakisdiethyl-phosphinat, Titanylbismethylethylphosphinat, Titantetrakismethylethylphosphinat, Zinkbisdiethylphosphinat, Zinkbismethylethylphosphinat und Mischungen davon.

Bevorzugt wird für die erfindungsgemäße flammwidrige Harzformulierung ein Dialkylphosphinsäuresalz mit einer mittleren Teilchengröße (d₅₀) von 0,1 bis 100 µm, besonders bevorzugt von 1 bis 20 µm eingesetzt.

Bevorzugt wird ein Dialkylphosphinsäuresalz mit ausschließlich kugelförmiger Partikelform eingesetzt, wobei das Dialkylphosphinsäuresalz möglichst keine Partikel in Form von Nadeln enthält.

Das Dialkylphosphinsäuresalz kann bevorzugt in Kombination mit anderen halogenfreien Flammschutzmitteln für die erfindungsgemäße flammwidrige Harzformulierung eingesetzt werden.

Bevorzugt enthalten solche Flammschutzkombinationen 0,1 bis 20 Gew.-% mindestens eines Dialkylphosphinsäuresalzes der Formel (I) und 0,1 bis 30 Gew.-% einer synergistischen Flammschutzkomponente.

Besonders bevorzugt enthalten die Flammschutzkombinationen 1 bis 10 Gew.-% mindestens eines Dialkylphosphinsäuresalzes der Formel (I) und 1 bis 20 Gew.-% einer synergistischen Flammschutzkomponente.

Bevorzugt handelt es sich bei der synergistischen Flammschutzkomponente um eine Sauerstoffverbindung des Siliciums, um Magnesiumverbindungen, um Zink- oder Aluminiumverbindungen.

Bevorzugt handelt es sich bei den Sauerstoffverbindungen des Siliciums um Salze und Ester der Orthokieselsäure und deren Kondensationsprodukte, um Silikate, Zeolithe und Kieselsäuren, um Glas-, Glas-Keramik oder Keramik-Pulver.

Bevorzugt handelt es sich bei den Magnesiumverbindungen um Magnesiumhydroxid, Hydrotalcite, Magnesium-Carbonate oder Magnesium-Calcium-Carbonate.

Bevorzugt handelt es sich bei den Zinkverbindungen um Zinkoxid, -stannat, -hydroxystannat, -phosphat, -borat oder -sulfide.

Bevorzugt handelt es sich bei den Aluminiumverbindungen um Aluminiumhydroxid oder-phosphat.

Bevorzugt handelt es sich bei der synergistischen Flammschutzkomponente um Stickstoffverbindungen und/oder Phosphor-Stickstoff-Verbindungen.

Bevorzugt handelt es sich bei den Stickstoffverbindungen um solche der Formeln (III) bis (VIII) oder Gemische davon 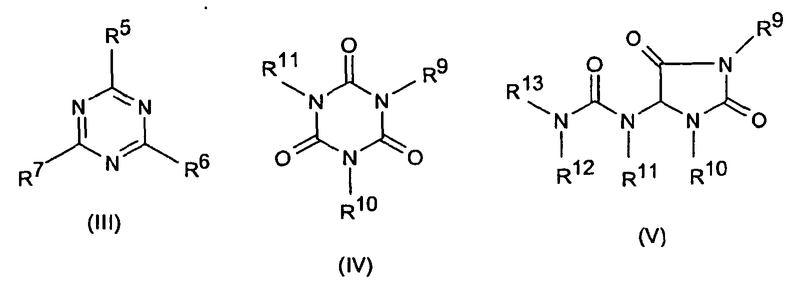 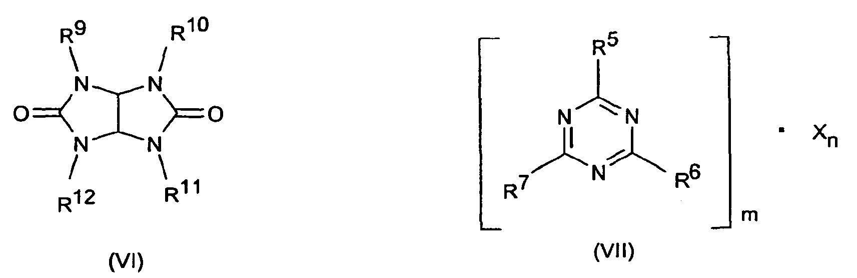 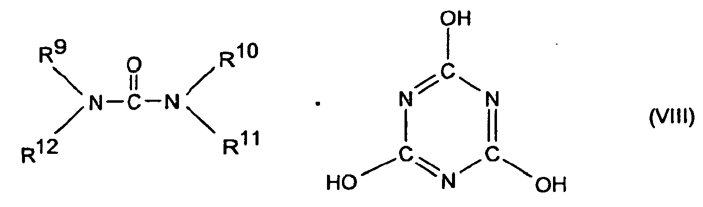 worin
- R⁵ bis R⁷: Wasserstoff, C₁-C₈-Alkyl, C₅-C₁₆-Cycloalkyl oder -Alkylcycloalkyl, möglicherweise substituiert mit einer Hydroxy- oder einer C₁-C₄-Hydroxyalkyl-Funktion, C₂-C₈-Alkenyl, C₁-C₈-Alkoxy, -Acyl, -Acyloxy, C₆-C₁₂-Aryl oder -Arylalkyl, -OR⁸ und -N(R⁸)R⁹, sowie N-alicyclisch oder N-aromatisch,
- R⁸: Wasserstoff, C₁-C₈-Alkyl, C₅-C₁₆-Cycloalkyl oder -Alkylcycloalkyl, möglicherweise substituiert mit einer Hydroxy- oder einer C₁-C₄-Hydroxyalkyl-Funktion, C₂-C₈-Alkenyl, C₁-C₈-Alkoxy, -Acyl, -Acyloxy oder C₆-C₁₂-Aryl oder -Arylalkyl,
- R⁹ bis R¹³: die gleichen Gruppen wie R⁸ sowie -O-R⁸,
- m und n: unabhängig voneinander 1, 2, 3 oder 4,
- X: Säuren, die Addukte mit Triazinverbindungen (III) bilden können,
bedeuten;
oder um oligomere Ester des Tris(hydroxyethyl)isocyanurats mit aromatischen Polycarbonsäuren.

Bevorzugt handelt es sich bei der Stickstoffverbindung oder der Phosphor-StickstoffVerbindung um Melamin, Melaminderivate der Cyanursäure, Melaminderivate der Isocyanursäure, Melaminsalze wie Melaminphosphat oder Melamindiphosphat, Melaminpolyphosphat, Dicyandiamid, Allantoin, Glycouril oder eine Guanidinverbindung wie Guanidincarbonat, Guanidinphosphat, Guanidinsulfat, Benzoguanamin und/oder um Kondensationsprodukte von Ethylenharnstoff und Formaldehyd und/oder um Ammoniumpolyphosphat und/oder um Carbodiimide.

Zusätzlich zu den oben genannten können als Stickstoff- oder Phosphor-Stickstoff-Komponente oligomere Ester des Tris(hydroxyethyl)isocyanurats mit aromatischen Polycarbonsäuren, wie sie in EP-A-0 584 567 beschrieben sind, und stickstoffhaltige Phosphate der Formeln (NH₄)_{y} H_{3-y} PO₄ bzw. (NH₄ PO₃)_{z}, wobei y Zahlenwerte von 1 bis 3 annehmen kann und z eine beliebig große Zahl ist (etwa 1 bis 10.000), typischerweise auch als Durchschnittswert einer Kettenlängenverteilung dargestellt, eingesetzt werden.

Bei der für die erfindungsgemäße flammwidrige Harzformulierung verwendete alkalilösliche Verbindung handelt es sich bevorzugt um ein Polymer mit einem Molekulargewicht zwischen 10.000 und 500.000 und einer Säurezahl zwischen 100 und 300 mg KOH/g. Geeignet sind insbesondere Acrylpolymere mit freien Carbonsäurefunktionen (Copolymere), die durch Copolymerisation einer ungesättigten Carbonsäure wie z. B. Methacrylsäure, Acrylsäure, Crotonsäure und Maleinsäure mit einem oder mehreren Estern z.B. der Methacrylsäure wie z. B. Methylmethacrylat, Ethylmethylmetacrylat, Propylmethacrylat, Butylmethacrylat, Benzylmethacrylat, 2-Ethylhexylmethacrylat, Hydroxyethylmetacrylat, Hydroxypropylmethacrylat oder Vinyl-Komponenten wie z. B. Styrol, Methylstyrol, Vinyltoluol oder Polyolefin-Verbindungen wie Butadien, Isopren, Chloropren sowie Verbindungen wie Vinylacetat oder Methacrylonitril erhalten werden können.

Bespiele von Copolymeren sind Copolymere aus Acrylaten und Methacrylaten wie Acrylsäure oder Methacrylsäure und Styrol oder substituierte Styrole, Phenolharze wie z. B. Novolake, Polyhydroxystyrol und Copolymere von Hydroxystyrol mit Alkylacrylaten, Acrylsäure und/oder Methacrylsäure.

Bevorzugte Copolymere sind Copolymere von Methylmethacrylat/Methacrylsäure, Copolymere von Benzylmethacrylat /Methacrylsäure, Copolymere von Methymetacrylat/Ethylacrylat/Methacrylsäure, Copolymere von Benzylmethacrylat/Methacrylsäure/Hydroxyethylmethacrylat, Copolymere von Methylmethacrylat/Butylmethacrylat/Methacrylsäure/Styrol und Copolymere von Methylmethacrylat/Benzylmethacrylat/Methacrylsäure/Hydroxyphenyl-methacrylat.

Bevorzugt geeignet für die alkalilösliche Komponente sind auch Polymere oder Oligomere, die mindestens zwei ungesättigte, ethylenische Doppelbindungen sowie mindestens eine Carboxylfunktion in der Molekülstruktur aufweisen. Solche Verbindungen werden z. B. durch Reaktion von einem gesättigten oder ungesättigten Säureanhydrid, welches mehr als ein reaktives Wasserstoffatom enthält, mit einem Reaktionsprodukt aus einer Epoxy-Komponente und einer ungesättigten Monocarbonsäure hergestellt (z. B.: EB^{®} 9696 von UCB Chemiclas; KAYARAD^{®} TCR1025 von Nippon Kayaku Co., LTD; NK^{®} OLIGO EA-6340, EA-7440 von Shin-Nakamura Chemical Co., LTD).

Geeignete polymerisierbare Monomere sind auch photopolymerisierbare Vinyl-Monomere. Hydroxyalkylacrylate wie z. B. 2-Hydroxyethylacrylat, 2-Hydroxybutylacrylat, Mono- oder Diacrylate von Glykolen wie z. B. Ethylenglycol, Polyethylenglycol, Propylenglycol, Acrylamide wie z. B. N,N-dimethylacrylamid, mehrwertige Acrylate von mehrwertigen Alkoholen oder Ethylenoxid/Propylenoxid Addukten wie z. B. Hexandiol, Trimethylolpropan, Pentaerythrit, Dipentaerythrit, Tris-hydroxyethylisocyanurat , Phenoxyacrylate, Bisphenol A-Diacrylate, Acrylate von Glycidylethern wie Glycerindiglycidylether und Melaminacrylate.

Die polymerisierbare Komponente kann auch als Mischung mit einer nicht polymerisierbaren, filmbildenden Komponente eingesetzt werden. Diese filmbildende Komponente ist ein physikalisch trocknendes Polymer oder eine Lösung des Polymeren in einem organischen Lösungsmittel, beispielsweise Nitrocellulose oder Celluloseacetobutyrat. Diese können aber auch chemisch bzw. thermisch härtbare Harze sein, wie z. B. Polyisocyanate, Polyepoxide oder Melaminharze sowie Polyimid. Die Mitverwendung von thermisch härtbaren Harzen ist für die Verwendung in so genannten Hybrid-Systemen von Bedeutung, die in einer ersten Stufe photopolymerisiert werden und in einer zweiten Stufe durch thermische Nachbehandlung vernetzt werden.

In den erfindungsgemäßen Harzformulierungen können als Photoinitiator alle Typen von Photoinitiatoren eingesetzt werden, welche bei der entsprechenden Bestrahlung freie Radikale bilden. Als Photoinitiator kommen beispielsweise Benzoinalkylether, Benzophenone, Benzilketale, 4-Aroyl-1,3-dioxolane, Dialkoxyacetophenone, alpha-Hydroxy- oder alpha-Aminoacetophenone wie z. B. (4-Methylthiobenzoyl)-1-methyl-1-morpholinoethan, alpha-Hydroxycycloalkylphenylketone, Mono- oder Bisacylphosphinoxide, oder Mischungen davon, in Frage.

Bei der Epoxy-Komponente handelt es sich bevorzugt um ein flüssiges oder festes Epoxidharz. Ein flüssiges Epoxidharz wir bevorzugt verwendet, wenn eine hohe Beständigkeit bei der Metallisierung gefordert wird. Für eine bessere Wasserbeständigkeit ist dagegen ein Epoxidharz bevorzugt, welches eine große Anzahl an Methylgruppen oder Benzolringen aufweist.

Bevorzugte Epoxidharze sind Harze vom Typ Bisphenol S wie z. B. BPS^{®}-200 von Nippon Kayaku Co., Ltd, EPX^{®} - 30 von ACR Co., Epiculon^{®} EXA-1514 von Dainippon Ink & Chemicals Inc oder Bisphenol A Harze wie Epiclon^{®} N-3050, N-7050, N-9050 von Dainippon Ink & Chemicals., XAC^{®} 5005, GT^{®} 7004, 6484T, 6099 von Huntsman; Bisphenol F Harze wie z. B. YDF^{®} 2004, YDF^{®} 2007 von Tohto Kasei Co., heterocyclische Epoxidharze wie z. B. TEPIC^{®} von Nissan Chemical Industries, Ltd., Araldite^{®} PT 810 von Huntsman, epoxidierte Novolake wie EPPN^{®} 201, EOCN^{®} 103, EOCN^{®} 1020, EOCN^{®} 1025 hergestellt von Nippon Kayaku Co., Ltd, ECN^{®} 278, ECN^{®} 292 und ECN^{®} 299 von Asahi Chemical Industry Co., Ltd., GY^{®} 1180, ECN^{®} 1273 und ECN^{®} 1299 von CIBA GEIGY AG, YDCN^{®} 220L, YDCN^{®} 220HH, YDCN^{®} 702, YDCN^{®} 704, YDPN^{®} 601 und YPDN^{®} 602 von Tohto Kasei Co., Epiclon^{®} 673, N^{®} 680, N^{®} 695, N^{®} 770 und N^{®} 775 hergestellt von Dainippon Ink & Chemicals Inc., aminofunktionelle Epoxidharze wie z. B. YH^{®} 1402 und ST^{®} 110 von Tohto Kasei Co., YL^{®} 931 und YL^{®} 933 von Yuka Shell Co., kautschukmodifizierte Epoxidharze wie Epiclon^{®} TSR-601 von Dainippon Ink & Chemicals Inc., EPX^{®} 84-2 und EPX^{®} 4061 von Asahi Denka Kogyo K.K., siliconmodifizierte Epoxidharze wie z. B. ^{®}-1359 von Asahi Denka Kogyo K.K. und andere Epoxidharze.

Zur Beschleunigung der Photopolymerisation können Amine zugesetzt werden, wie z. B. Triethanolamin, N-Methyl-diethanolamin, p-Dimethylaminobenzoesäureethylester oder Michlers Keton. Die Wirkung der Amine kann verstärkt werden durch den Zusatz von aromatischen Ketonen vom Typ des Benzophenons. Als Sauerstofffänger brauchbare Amine sind beispielsweise substituierte N,N-dialkylaniline, wie sie in der EP-A-0 339 841 beschrieben sind.

Eine Beschleunigung der Photopolymerisation kann weiterhin durch Zusatz von Photosensibilisatoren geschehen, welche die spektrale Empfindlichkeit verschieben bzw. verbreitern. Dies sind insbesondere aromatische Carbonylverbindungen wie z. B. Benzophenon-, Thioxanthon-, Anthrachinon- und 3-Acylcumarinderivate sowie 3-(Aroyl-methylen)-thiazoline, aber auch Eosin-, Rhodamin- und Erythrosin-Farbstoffe.

Die erfindungsgemäßen Harzformulierungen können je nach geplantem Anwendungszweck und je nach Art der Formulierung lösemittelfrei eingesetzt werden oder aber auch übliche Lösemittel enthalten.

Geeignete Lösungsmittel, die alleine oder in Gemischen eingesetzt werden können, sind z. B.: Ketone, wie Aceton, Dimethylketon, Diethylketon, Methylisobutylketon, Cyclohexanon, Cyclopentanon, Cycloheptanon, Isophoron, Methoxyhexanon, Acetonylaceton, Acetonphenon, Benzylethylketon, 3,3,5-Trimethylcyclohexanon, Mesityloxid; Alkohole wie Methanol, Ethanol, Propanol, Butanol, Hexanol, Cyclohexanol, Furfurylalkohol, Tetrahydrofurfurylalkohol, Benzylalkohol, monoalkylierte Glykole wie Methylglykol, Ethylglykol, Triethylenglykol-monoethyl- oder -monobutylether, Glykole wie Ethylen-, Propylen- oder Butylenglykol und deren Oligomere wie Triethylenglykol; aliphatische und aromatische Kohlenwasserstoffe wie Pentan, Hexan, Cyclohexan, Methylcyclohexan, Benzol, Toluol oder Xylol, Ether wie Diethylether, Dibutylether, Tetrahydrofuran, Dioxan, Ethylenglykoldimethylether, Diethylenglykoldimethylether, Carbonsäureester wie Methyl-, Ethyl-, Propyl-, Butyl- und Isopropyl- sowie Phenylacetat, Propionsäure-methylester, Glykolsäurebutylester, Ethylglykolmono- oder -diacetat, Methyl- oder Ethylglykolsäureacetat; Lactone wie Butyro- Valerolacton; Säureamide wie Dimethyl-formamid, Dimethylacetamid, Hexamethylphosphorsäuretriamid; Sulfone wie z. B. Dimethylsulfon, Dibutylsulfon oder Tetramethylensulfon, Stoffgemische von Kohlenwasserstoffen wie z. B. Petrolether, Lösungsmittelnaphtha oder hydriertes Naphtha.

Zusätzlich können die erfindungsgemäßen Harzformulierungen Füllstoffe enthalten. Die eingesetzten Füllstoffe sollen feinteilig sein, d. h. die Partikelgröße des Füllstoffs muss kleiner sein als der Abstand von Leitern in gedruckten Schaltungen. Die mittlere Partikelgröße kann 0,01 bis 10 µm, vorzugsweise 0,01 bis 5 µm betragen. Besonders bevorzugt sind mikronisierte Füllstoffe mit einer mittleren Partikelgröße von 0,01 bis 1,5 µm.

Geeignete Füllstoffe sind kolloidales oder hydrophobiertes Siliziumdioxid, Mikrotalkum, Mikroglimmer, Kaolin, Aluminiumoxide, Magnesiumsilikat, Aluminiumhydroxid, Calciumsilikat, Aluminiumsilikat, Magnesiumcarbonat, Calciumcarbonat, Zirkoniumsilikat, Porzellanmehl, Antimontrioxid, Titandioxid, Bariumtitanat oder Bariumsulfat oder Gemische der genannten Füllstoffe.

Die Füllstoffe sind vorteilhaft mit einem Haftvermittler versehen, um eine gute Haftung zwischen Polymermatrix und Füllstoff zu erzielen. Übliche Haftvermittler sind z. B. Trialkoxysilane, die funktionelle Gruppen wie z. B. -OH, -NH₂, Epoxid- oder Vinylgruppen enthalten. Beispiele sind Trialkoxysilylglycidoxy- oder -aminopropan und Trialkoxyvinyl- oder -allylsilan. Die Alkoxygruppe kann 1 bis 12 C-Atome enthalten und z. B. Methyl, Ethyl, Propyl, Butyl, Hexyl, Octyl oder Dodecyl sein.

Weitere übliche Zusätze sind - je nach Verwendungszweck - optische Aufheller, Pigmente, Farbstoffe, Netzmittel oder Verlaufhilfsmittel. Zur Härtung dicker und pigmentierter Beschichtungen eignet sich der Zusatz von Mikro-Glaskugeln oder pulverisierter Glasfasern, wie z. B. im US-A-5 013 768 beschrieben.

Besonders zweckmäßig ist der Zusatz von Antiabsetzmitteln zur Erhöhung der Lagerstabilität der erfindungsgemäßen flammgeschützten Harzformulierung und zum Erhalt der Verarbeitbarkeit. Hiermit wird vermieden, dass sich die Füllstoffe inklusive das Flammschutzmittel absetzen und daher vor der Verarbeitung erneut gleichmäßig verteilt werden müssen. Das Antiabsetzmittel kann in Mengen von 0,09 bis 4 Gew.-% zugegeben werden, bezogen auf den Gesamtgehalt an Füllstoff in der Formulierung. Beispiele für solche Antiabsetzmittel sind hochdispere Kieselsäure, Montmorillonit, Bentone oder Xonolith.

Die erfindungsgemäße flammgeschützte Harzformulierung wird mit an sich üblichen Verfahren durch Mischen der Komponenten, bevorzugt unter Anwendung hoher Scherkräfte hergestellt. Es hat sich als vorteilhaft erwiesen, das Flammschutzmittel und gegebenenfalls andere Füllstoffe zunächst in einem geeigneten Medium zu dispergieren, z. B. in einem Lösungsmittel. Bevorzugt sind Ketone wie z. B. Aceton oder Methylethylketon, aber auch Stoffgemische von Kohlenwasserstoffen wie z. B. Naphtha oder Petrolether.

Der Zusatz eines Haftvermittlers kann gegebenenfalls hilfreich sein. Die so erzeugten Pasten vermeiden eine zu lange und oftmals für die lichtempfindlichen Substanzen schädliche Dispergierzeit. Solche Pasten können beispielsweise in Kugelmühlen, Walzenstühlen oder Highspeed-Dissolvern hergestellt werden.

Die erfindungsgemäße flammgeschützte Harzformulierung kann mittels bekannter Beschichtungsverfahren gleichförmig auf ein Substrat aufgebracht werden, z. B. durch Schleudern, Tauchen, Rakelbeschichtung, Vorhanggießverfahren, Aufpinseln, Sprühen, speziell durch elektrostatisches Sprühen und Reverse-Roll-Beschichtung Es ist auch möglich, die lichtempfindliche Schicht auf einen temporären, flexiblen Träger zu bringen und dann durch Schichtübertragung via Lamination das endgültige Substrat, z. B. eine kupferkaschierte Leiterplatte, zu beschichten.

Die Auftragsmenge (Schichtdicke) und Art des Substrates (Schichtträger) sind abhängig von dem gewünschten Anwendungsgebiet. Der Schichtdickenbereich umfasst im allgemeinen Werte von ca. 0,1 µm bis mehr als 50 µm.

Bevorzugt handelt es sich bei den flexiblen Leiterplatten (Substrat) um unkaschierte oder kupferkaschierte Kunststofffolien auf Basis von Polyester wie Polyethylenterephthalat (PET) oder Polyethylennaphthalat.

Nach dem Beschichten des Substrates, besonders gedruckte Schaltungen, wird das Lösungsmittel unter Erwärmen zur Erzeugung klebfreier Schichten für die weitere Verarbeitung in Öfen, bevorzugt bei 80-90 °C entfernt.

Das beschichtete Substrat wird dann belichtet. Der Begriff "bildmäßige" Belichtung beinhaltet hierbei sowohl die Belichtung durch eine Photomaske, die ein vorbestimmtes Muster enthält, beispielsweise ein Diapositiv, die Belichtung durch einen Laserstrahl der beispielsweise computergesteuert über die Oberfläche des beschichteten Substrates bewegt wird und auf diese Weise ein Bild erzeugt, sowie die Bestrahlung mit computergesteuerten Elektronenstrahlen.

Nach der bildmäßigen Belichtung des Materials und vor der Entwicklung kann es vorteilhaft sein, für kürzere Zeit eine thermische Behandlung durchzuführen. Dabei werden nur die belichteten Teile thermisch gehärtet. Die angewandten Temperaturen liegen bevorzugt bei 50-150 °C, besonders bevorzugt bei 80-130 °C; die Zeit für die thermische Behandlung liegt in der Regel zwischen 0,25 und 100 Minuten.

Nach der Belichtung und gegebenenfalls thermischen Behandlung werden die unbelichteten Stellen des Schutzlackes in an sich bekannter Weise mit einem Entwickler entfernt.

Die erfindungsgemäße flammgeschützte Harzformulierung ist kann wässrig-alkalisch entwickelt werden. Geeignete wässrig-alkalische Entwickler-Lösungen sind insbesondere wässrige Lösungen von Tetraalkylammoniumhydroxiden oder von Alkalimetallsilikaten, -phosphaten, -hydroxiden und -carbonaten. Diesen Lösungen können gegebenenfalls noch kleinere Mengen an Netzmitteln und/oder organischen Lösungsmitteln zugesetzt sein. Typische organische Lösungsmittel, die den Entwicklerflüssigkeiten in kleinen Mengen zugesetzt werden können, sind beispielsweise Cyclohexanon, 2-Ethoxyethanol, Toluol, Aceton sowie Mischungen solcher Lösungsmittel.

Danach kann der Schutzlack nochmals bei höheren Temperaturen ausgehärtet werden. Bevorzugt ist eine Temperatur von > 150 °C.

Die anschließend erhaltenen gedruckten bzw. flexiblen Schaltungen weisen eine Schutzschicht, die die erfindungsgemäße flammgeschützte Harzformulierung enthält auf, die die an sie gestellten Anforderungen erfüllt. Die elektrischen Eigenschaften sind nicht vermindert und die Beständigkeit auf dem Lötbad ist erheblich verbessert, so dass sogar mehrere Zyklen auf dem Lötbad möglich sind.

Die physikalischen Eigenschaften der Produkte aus den nachfolgenden Beispielen wurden auf folgende Weise bestimmt. Die erhaltenen Ergebnisse sind in Tabelle I aufgeführt.

### Brennbarkeit

Zur Herstellung der Proben wurde der Lötstopplack zunächst einseitig auf einen 25 µm dicken, 200 mm x 50 mm Polyimidfilm (CAPTON^{™} 100 H, Toray-DuPont Co. Ltd.) mittels Siebdruck aufgetragen. Nach dem Trocknen bei 70 °C wurde auf die gleiche Weise auf der Gegenseite des Polyimidfilms der Lötstopplack aufgebracht. Danach wurde auf übliche Weise durch eine Fotovorlage abgedeckt belichtet, entwickelt und thermisch gehärtet.

Vor dem Test wurde die Probe bei 23°C und einer relativen Luftfeuchtigkeit von 50 % für 48 h konditioniert. Der Brandtest wurde entsprechend UL 94 -VTM nach Underwriters Laboratories Inc. U.S.A. (UL) durchgeführt.

### Klebrigkeit

Nach Applikation des Lötstopplackes auf ein Substrat und anschließender Trocknung bei 70 °C wurde die Probe auf Raumtemperatur abgekühlt und durch Berühren mit dem Finger die Klebrigkeit der Lackoberfläche nach folgender Skala beurteilt:
A: klebefrei
B: leicht klebrig
C: klebrig

### Graustufe/Photosensibilität

Zur Bestimmung der Graustufe wurde ein in mehreren Stufen (21 stufiger Stoufferkeil) immer lichtundurchlässiger werdender Filmstreifen auf den Lötstopplack gelegt. Nach dem Entwicklungsprozess wurde die Stufe beurteilt, die gerade noch abgewaschen werden konnte. Je höher die Graustufe ist, desto höher ist die Photosensibilität.

### Flexibilität

Ein mit dem flammgeschützten Lötstopplack beschichteter Polyimidfilm wurde bei einem Druck von 0,5 MPa für 1 Sekunde um 180° gefaltet. Der Lötstopplack war dabei nach außen gerichtet. Anschließend wurde die Probe unter den Lichtmikroskop nach Rissen im Lötstopplack untersucht:
A: keine Risse im gehärteten Lötstopplack
C: Risse im Lötstopplack

### Lötbadbeständigkeit

Zur Simulation des Lötprozesses wurde der Lötstopplack nach Applikation auf dem kupferkaschierten Polyimidfilm mit einem Flussmittel (H-10F) beschichtet. Danach wurde die Probe 5 Sekunden schwimmend auf ein 260°C heißes Lötbad gelegt. Dieser Zyklus wurde wiederholt und vor jeder Wiederholung visuell Veränderungen des Lötstopplackes wie z. B. die Bildung von Blasen geprüft. Die maximale Anzahl von Zyklen ohne Veränderung wurde notiert.

### PCT (Pressure Cooker Test)

Mit Hilfe des High-Pressure Cooker Tests lässt sich generell der Verbund zwischen dem Lötstopplack und dem Substrat prüfen. Dazu wurden entsprechend der IPC-TM-650 2.6.16 Probekörper von dem mit flammgeschützten Lötstopplack beschichteten kupferkaschierten Polyimidfilm in einem Autoklaven, der vorher mit einer bestimmten Menge Wasser befüllt wurde, positioniert. Das Wasser wurde anschließend auf Siedetemperatur gebracht, wodurch sich ein Überdruck (0,2 MPa) im Autoklaven aufbaute. Nach 96 h Lagerung unter diesen Bedingungen wurden die Probekörper entnommen und 10 min bei Raumtemperatur konditioniert. Anschließend wurden die Proben in ein Lötbad mit einer Lötbadtemperatur von 288 °C für 20 Sekunden getaucht. Danach wurden die Proben optisch auf Delaminationen, Ausblühungen und Verfärbungen untersucht.
A: keine Delaminationen, Verfärbungen oder Ausblühungen
B: vereinzelte Delaminationen, Verfärbungen oder Ausblühungen
C: starke Delaminationen, Verfärbungen und Ausblühungen
Für die Untersuchungen wurde eine lichtempfindliche Harzformulierung verwendet.

Die einzelnen Lackkomponenten wurden miteinander vermischt und anschließend auf ein Substrat aufgezogen. Wenn kein Trockenfilm-Lötstopplack verwendet wurde, wurde zunächst das Lösungsmittel durch Trocknen bei höheren Temperaturen entfernt. Danach wurde das beschichtete Substrat gegebenenfalls durch eine Bildmaske belichtet und anschließend durch Entfernung der nicht ausgehärteten Bereiche durch Waschen mit einer wässrigen, alkalischen Lösung entwickelt. Die erhaltene Schutzschicht wurde dann durch Initiierung der Vernetzung zwischen der Carbonsäure und der Epoxy-Komponente thermisch gehärtet.

Die Erfindung wird durch die nachstehenden Beispiele erläutert.

### Beispiel 1

Ein Lötstopplack wurde durch Mischen folgender Komponenten hergestellt: 40 Gew.-% EA^{®}6340 (Epoxyacrylat (Novolak-Typ) mit Carbonsäuregruppen, Shin-Nakamara Chemical Co., Ltd)
- 5 Gew.-%: Dipentaerythritol-hexaacrylat (Aldrich Chemical Co.)
- 10 Gew.-%: Epiclon^{®} N-695 (Kresol-Novolak, Dainippon Ink & Chemicals Inc.)
- 4 Gew.-%: IRGACURE^{®} 907 (Initiator für Photopolymerisation, Ciba Geigy Corp.)
- 0,5 Gew.-%: KAYACURE^{®} DETX-S (Initiator für Photopolymerisation, Nippon Kayaku Co., Ltd.)
- 5 Gew.-%: Aerosil^{®} 380 (Siliciumdioxid, Degussa)
- 17 Gew.-%: Bariumsulfat (Sachtleben Bergbau GmbH)
- 15 Gew.-%: Aluminiumsalz der Diethylphosphinsäure
- 0,5 Gew.-%: Hostaperm^{®} Blue A4R (Phthalocyanin blau, Clariant Produkte Deutschland GmbH)
- 1 Gew.-%: SWASOL^{®} 1500 (Gemisch aromatischer Lösungsmittel, Cosmo Oil Co., Ltd.)
- 1 Gew.-%: MODAFLOW^{®} (Verlaufsadditiv, MONSANTO COMPANY)
- 1 Gew.-%: Curezol^{®} VT (2,4-Diamino-6-vinyl-s-triazin, Shikoku Chemicals Corp.)
Durch mehrfaches Vermischen in einem Dreiwalzenstuhl wurde eine Mischung entsprechend der jeweils aufgeführten Zusammensetzung hergestellt. Anschließend wurde die Mischung mittels Siebdruck auf ein Substrat aufgetragen und für 30 Minuten bei 70 °C getrocknet. Als Substrat wurde
a) ein einseitig kupferkaschierter Polyimidfilm (UPISEL^{™} N, Ube Kosan Co., Ltd, Dicke: 25 µm) oder
b) ein 25 µm dicker unkaschierter Polyimidfilm verwendet (CAPTONE^{™} 100 H, Toray-DuPont Co., Ltd).

Nach der Applikation auf das Substrat wurde der Lötstopplack durch eine Fotovorlage mit einer UV-Lampe (Belichtungsenergie: 500 mJ/cm², Emmissionsmaximum 365 nm) belichtet. Die nicht belichteten Bereiche wurden anschließend mit einer 1 %igen wässrigen Natriumcarbonat-Lösung entfernt. Der Lötstopplack selbst wurde dann nochmals für 60 min bei 150 °C thermisch nachgehärtet.

### Beispiel 2

Analog Beispiel 1 wurde folgender Lötstopplack hergestellt und geprüft. Das Aluminiumsalz der Diethylphosphinsäure wurde durch eine Flammschutzmischung aus dem Aluminiumsalzes der Diethylphosphinsäure und Aluminiumhydroxid ersetzt:
- 30 Gew.-%: EA^{®}6340
- 5 Gew.-%: Dipentaerythritol-hexaacrylat (Aldrich Chemical Co.)
- 10 Gew.-%: Epiclon^{®} N-695
- 4 Gew.-%: IRGACURE^{®} 907
- 0,5 Gew.-%: KAYACURE^{®} DETX-S
- 5 Gew.-%: Aerosil^{®} 380
- 17 Gew.-%: Bariumsulfat (Sachtleben Bergbau GmbH)
- 10 Gew.-%: Aluminiumsalz der Diethylphosphinsäure
- 15 Gew.-%: Aluminiumhydroxid (HIGILITE^{®} H43M, Showa Denko K.K.)
- 0,5 Gew.-%: Hostaperm^{®} Blue A4R
- 1 Gew.-%: SWASOL^{®} 1500
- 1 Gew.-%: MODAFLOW^{®}
- 1 Gew.-%: Curezol^{®} VT

### Beispiel 3

Analog Beispiel 1 wurde folgender Lötstopplack hergestellt und geprüft. Das Aluminiumsalz der Diethylphosphinsäure wurde durch eine Flammschutzmischung aus dem Aluminiumsalzes der Diethylphosphinsäure und Melamin ersetzt:
- 40 Gew.-%: EA^{®} 6340
- 5 Gew.-%: Dipentaerythritol-hexaacrylat (Aldrich Chemical Co.)
- 10 Gew.-%: Epiclon^{®} N-695
- 4 Gew.-%: IRGACURE^{®} 907
- 0,5 Gew.-%: KAYACURE^{®} DETX-S
- 5 Gew.-%: Aerosil^{®} 380
- 17 Gew.-%: Bariumsulfat (Sachtleben Bergbau GmbH)
- 10 Gew.-%: Aluminiumsalz der Diethylphosphinsäure
- 5 Gew.-%: Melamin (Melamine^{®} Grade 003, DSM, NL)
- 0,5 Gew.-%: Hostaperm^{®} Blue A4R
- 1 Gew.-%: SWASOL^{®} 1500
- 1 Gew.-%: MODAFLOW^{®}
- 1 Gew.-%: Curezol^{®} VT

### Beispiel 4

Analog Beispiel 1 wurde folgender Lötstopplack hergestellt und geprüft. Das Aluminiumsalz der Diethylphosphinsäure wurde durch eine Flammschutzmischung aus dem Aluminiumsalzes der Diethylphosphinsäure und Melamincyanurat ersetzt:
- 30 Gew.-%: EA^{®}6340
- 5 Gew.-%: Dipentaerythritol-hexaacrylat (Aldrich Chemical Co.)
- 10 Gew.-%: Epiclon^{®} N-695
- 4 Gew.-%: IRGACURE^{®} 907
- 0,5 Gew.-%: KAYACURE^{®} DETX-S
- 5 Gew.-%: Aerosil^{®} 380
- 17 Gew.-%: Bariumsulfat (Sachtleben Bergbau GmbH)
- 10 Gew.-%: Aluminiumsalz der Diethylphosphinsäure
- 10 Gew.-%: Melamincyanurat (DSM, NL)
- 0,5 Gew.-%: Hostaperm^{®} Blue A4R
- 1 Gew.-%: SWASOL^{®} 1500
- 1 Gew.-%: MODAFLOW^{®}
- 1 Gew.-%: Curezol^{®} VT

### Beispiel 5

Analog Beispiel 1 wurde folgender Lötstopplack hergestellt und geprüft. Das Aluminiumsalz der Diethylphosphinsäure wurde durch eine Flammschutzmischung aus dem Aluminiumsalzes der Diethylphosphinsäure und Melaminphosphat ersetzt:
- 30 Gew.-%: EA^{®}-6340
- 5 Gew.-%: Dipentaerythritol-hexaacrylat (Aldrich Chemical Co.)
- 10 Gew.-%: Epiclon^{®} N-695
- 4 Gew.-%: IRGACURE^{®} 907
- 0,5 Gew.-%: KAYACURE^{®} DETX-S
- 5 Gew.-%: Aerosil^{®} 380
- 17 Gew.-%: Bariumsulfat (Sachtleben Bergbau GmbH)
- 10 Gew.-%: Aluminiumsalz der Diethylphosphinsäure
- 10 Gew.-%: Melaminphosphat (DSM, NL)
- 0,5 Gew.-%: Hostaperm^{®} Blue A4R
- 1 Gew.-%: SWASOL^{®} 1500
- 1 Gew.-%: MODAFLOW^{®}
- 1 Gew.-%: Curezol^{®} VT

### Beispiel 6

Analog Beispiel 1 wurde folgender Lötstopplack hergestellt und geprüft. Das Aluminiumsalz der Diethylphosphinsäure wurde durch eine Flammschutzmischung aus dem Aluminiumsalzes der Diethylphosphinsäure und Melamin sowie Zinkborat ersetzt:
- 30 Gew.-%: EA^{®}6340
- 5 Gew.-%: Dipentaerythritol-hexaacrylat (Aldrich Chemical Co.)
- 10 Gew.-%: Epiclon^{®} N-695
- 4 Gew.-%: IRGACURE^{®} 907
- 0,5 Gew.-%: KAYACURE^{®} DETX-S
- 5 Gew.-%: Aerosil^{®} 380
- 17 Gew.-%: Bariumsulfat (Sachtleben Bergbau GmbH)
- 7 Gew.-%: Aluminiumsalz der Diethylphosphinsäure
- 10 Gew.-%: Melamin (DSM, NL)
- 3 Gew.-%: Zinkborat (Firebrake^{®} ZB, US Borax & Chemical Corporation, USA)
- 0,5 Gew.-%: Hostaperm^{®} Blue A4R
- 1 Gew.-%: SWASOL^{®} 1500
- 1 Gew.-%: MODAFLOW^{®}
- 1 Gew.-%: Curezol^{®} VT

### Vergleichsbeispiel 1

Analog Beispiel 1 wurde folgender Lötstopplack zum Vergleich hergestellt und geprüft. Statt des Aluminiumsalzes der Diethylphosphinsäure wurde ein handelsüblicher Phosphorsäureester als Flammschutzmittel verwendet:
- 40 Gew.-%: EA^{®}6340
- 5 Gew.-%: Dipentaerythritol-hexaacrylat (Aldrich Chemical Co.)
- 10 Gew.-%: Epiclon^{®} N-695
- 4 Gew.-%: IRGACURE^{®} 907
- 0,5 Gew.-%: KAYACURE^{®} DETX-S
- 5 Gew.-%: Aerosil^{®} 380
- 17 Gew.-%: Bariumsulfat (Sachtleben Bergbau GmbH)
- 15 Gew.-%: PX^{®} 200 (aromatischer Phosphorsäureester, Daihachi Chemical Industry Co., Ltd)
- 0,5 Gew.-%: Hostaperm^{®} Blue A4R
- 1 Gew.-%: SWASOL^{®} 1500
- 1 Gew.-%: MODAFLOW^{®}
- 1 Gew.-%: Curezol^{®} VT

### Vergleichsbeispiel 2

Analog Beispiel 1 wurde folgender Lötstopplack zum Vergleich hergestellt und geprüft. Statt des Aluminiumsalzes der Diethylphosphinsäure wurde ein handelsübliches bromiertes Epoxidharz als Flammschutzmittel verwendet:
- 40 Gew.-%: EA^{®}-6340
- 5 Gew.-%: Dipentaerythritol-hexaacrylat (Aldrich Chemical Co.)
- 10 Gew.-%: Epiclon^{®} N-695
- 4 Gew.-%: IRGACURE^{®} 907
- 0,5 Gew.-%: KAYACURE^{®} DETX-S
- 5 Gew.-%: Aerosil^{®} 380
- 17 Gew.-%: Bariumsulfat (Sachtleben Bergbau GmbH)
- 20 Gew.-%: EPIKOTE^{®} 5051 (bromiertes Epoxidharz, Japan Epoxy Resins Co., Ltd)
- 0,5 Gew.-%: Hostaperm^{®} Blue A4R
- 1 Gew.-%: SWASOL^{®} 1500
- 1 Gew.-%: MODAFLOW^{®}
- 1 Gew.-%: Curezol^{®} VT

Der mit der erfindungsgemäßen Harzformulierung hergestellte Lötstopplack hat eine ausgezeichnete Flexibilität, gute Haftung und Isolationseigenschaften sowie eine sehr gute Flammwidrigkeit, exzellenter Lötbadbeständigkeit, Feuchtebeständigkeit und Temperaturstabilität (Tabelle 1). Die erfindungsgemäßen flammgeschützten Harzformulierungen können als Schutzlack sowohl für starre als auch für flexible Leiterplatten verwendet werden

Insbesondere der mit der erfindungsgemäßen Harzformulierung hergestellte und damit mit dem Aluminiumsalz der Diethylphosphinsäure modifizierte Lötstopplack für starre und flexible Leiterplatten ist durch Strahlung vernetzbar. Der mit der erfindungsgemäßen Harzformulierung hergestellte flammgeschützte Lötstopplack zeigt eine sehr gute Lötbadbeständigkeit. Dagegen wurden Ausblühungen, Verfärbungen oder Delaminationen nicht beobachtet. Vernetzungsgrad und Haftung des mit der erfindungsgemäßen Harzformulierung hergestellten flammgeschützten Lötstopplackes ist auf allen in der Leiterplattenindustrie üblichen Untergründen, insbesondere auf Kupfer, Blei/Zinn sowie Epoxidharz und Polyimid, sehr gut.
Der mit der erfindungsgemäßen Harzformulierung hergestellte und damit mit dem Aluminiumsalz der Diethylphosphinsäure modifizierte Lötstopplack kann nach der Belichtung leicht und vor allem umweltfreundlich mit alkalischen wässrigen Lösungen entwickelt werden. Der gehärtete Lötstopplack ist nicht spröde, sondern zeigt eine exzellente Flexibilität, was insbesondere für die Anwendung in einer flexiblen Leiterplatte von großem Interesse ist.

Der mit der erfindungsgemäßen Harzformulierung hergestellte und damit mit dem Aluminiumsalz der Diethylphosphinsäure modifizierte Lötstopplack ist halogenfrei und zeigt ein ausgezeichnetes Brandverhalten. Bereits bei relativ niedriger Dosierung wird eine VTM-O Einstufung nach UL 94 erreicht.

**Tabelle 1: Physikalische Eigenschaften**

| | Beispiel 1 | Beispiel 2 | Beispiel 3 | Beispiel 4 | Beispiel 5 | Beispiel 6 | Vergleichsbeispiel 1 | Vergleichsbeispiel 2 |
|---|---|---|---|---|---|---|---|---|
| Schichtdicke (µm) | 25 | 25 | 25 | 25 | 25 | 25 | 25 | 25 |
| Brennbarkeit (UL 94) | VTM-0 | VTM-0 | VTM-0 | VTM-0 | VTM-0 | VTM-0 | VTM-1 | VTM-0 |
| Klebrigkeit | A | A | A | A | A | B | C | C |
| Graustufe/ Photosensibilität | 8 | 8 | 8 | 8 | 8 | 7 | 7 | 8 |
| Flexibilität | A | A | A | A | A | A | A | C |
| Lötbadbeständigkeit | 4 | 3 | 3 | 3 | 3 | 3 | 2 | 4 |
| PCT | A | A | A | A | B | A | C | C |

## Patentansprüche

1. Flammwidrige Harzformulierung, enthaltend jeweils mindestens eine Flammschutzkomponente, eine alkalilösliche Komponente, ein polymerisierbares Monomer, einen Photoiniator und eine Epoxy-Komponente, **dadurch gekennzeichnet, dass** sie als Flammschutzkomponente ein Phosphinsäuresalz der Formel (I) enthält, 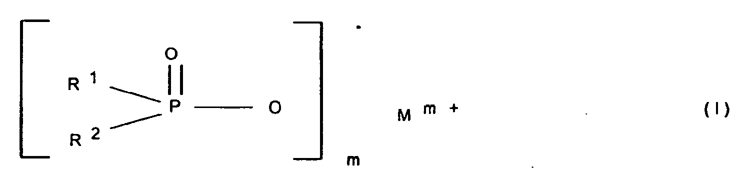 worin
R¹, R² gleich oder verschieden sind und unabhängig voneinander C₁-C₆-Alkyl, linear oder verzweigt und/oder Aryl;
M Mg, Ca, Al, Sb, Sn, Ge, Ti, Zn, Fe, Zr, Ce, Bi, Sr, Mn, Li, Na, K und/oder eine protonierte Stickstoffbase und m 1 bis 4 bedeuten.

2. Flammwidrige Harzformulierung nach Anspruch 1, **dadurch gekennzeichnet, dass** R¹, R² gleich oder verschieden sind und Methyl, Ethyl, n-Propyl, iso-Propyl, n-Butyl, tert.-Butyl, n-Pentyl und/oder Phenyl bedeuten.

3. Flammwidrige Harzformulierung nach Anspruch 1 oder 2, **dadurch gekennzeichnet, dass** es sich bei dem Phosphinsäuresalz der Formel (I) um das Aluminiumsalz der Diethylphosphinsäure handelt.

4. Flammwidrige Harzformulierung für einen Lötstopplack nach einem oder mehreren der Ansprüche 1 bis 3, **dadurch gekennzeichnet, dass** das Aluminiumsalz der Diethylphosphinsäure eine mittlere Teilchengröße (d₅₀) von 0,1 bis 100 µm, bevorzugt von 1 bis 20 µm, aufweist.

5. Flammwidrige Harzformulierung nach einem oder mehreren der Ansprüche 1 bis 4, **dadurch gekennzeichnet, dass** es sich bei der alkalilösliche Komponente um ein modifiziertes Epoxyacrylat handelt.

6. Flammwidrige Harzformulierung nach einem oder mehreren der Ansprüche 1 bis 5, **dadurch gekennzeichnet, dass** es sich bei dem polymerisierbaren Monomeren um mehrwertige Acrylate von mehrwertigen Alkoholen handelt.

7. Flammwidrige Harzformulierung nach Anspruch 6, **dadurch gekennzeichnet, dass** es sich bei den mehrwertigen Alkoholen um Pentaerythrit und/oder Dipentaerythrit handelt.

8. Flammwidrige Harzformulierung nach einem oder mehreren der Ansprüche 1 bis 7, **dadurch gekennzeichnet, dass** es sich bei dem Photoinitiator um alpha-Aminoacetophenone handelt.

9. Flammwidrige Harzformulierung nach Anspruch 8, **dadurch gekennzeichnet, dass** es sich dabei um(4-Methylthiobenzoyl)-1-methyl-1-morpholinoethan handelt.

10. Flammwidrige Harzformutierung nach einem oder mehreren der Ansprüche 1 bis 9, **dadurch gekennzeichnet, dass** es sich bei der Epoxyverbindung um einen epoxidierten Novolak handelt.

11. Flammwidrige Harzformulierung nach einem oder mehreren der Ansprüche 1 bis 10, **dadurch gekennzeichnet, dass** die flammwidrige Harzformulierung mindestens
0,1-50 Gew.-% Flammschutzkomponente,
0,1-65 Gew.-% alkalilösliche Komponente,
0,1-65 Gew.-% polymerisierbares Monomer,
0,1-15 Gew.-% Photoiniator und
0,1-25 Gew.-% Epoxy-Komponente
enthält.

12. Flammwidrige Harzformulierung nach einem oder mehreren der Ansprüche 1 bis 11, **dadurch gekennzeichnet, dass** die flammwidrige Harzformulierung mindestens
5-20 Gew.-% Flammschutzkomponente,
30-40 Gew.-% alkalilösliche Komponente,
5-10 Gew.-% polymerisierbares Monomer,
4-5 Gew.-% Photoiniator und
5-10 Gew.-% Epoxy-Komponente
enthält.

13. Flammwidrige Harzformulierung nach einem oder mehreren der Ansprüche 1 bis 12, **dadurch gekennzeichnet, dass** die flammwidrige Harzformulierung weiterhin 0,1 bis 30 Gew.-%, bevorzugt 1 bis 20 Gew.-% mindestens einer synergistischen Flammschutzkomponente, bei der es sich um Melamin, Melaminderivate der Cyanursäure, Melaminderivate der Isocyanursäure, Melaminsalze wie Melaminphosphat, Melaminpolyphosphat oder Melamindiphosphat, Dicyandiamid oder eine Guanidinverbindung wie Guanidincarbonat, Guanidinphosphat, Guanidinsulfat und/oder um Kondensationsprodukte von Ethylenharnstoff und Formaldehyd oder Ammoniumpolyphosphat; um Sauerstoffverbindungen des Siliciums, wobei es sich dabei um Orthokieselsäure und deren Kondensationsprodukte, um Silikate, Zeolithe und Kieselsäuren handelt; oder um Aluminiumhydroxid handelt, enthält.

14. Verwendung der flammwidrigen Harzformulierung nach einem oder mehreren der Ansprüche 1 bis 13 in oder zur Herstellung von Beschichtungen für die Elektronik und Elektrotechnik.

15. Verwendung der flammwidrigen Harzformulierung nach einem oder mehreren der Ansprüche 1 bis 14 als Lötstopplack.

16. Verfahren zur Herstellung flammgeschützter Lötstopplacke gemäß Anspruch 15, **dadurch gekennzeichnet, dass** eine dünne Schicht des Lötstopplackes durch Schleudern, Tauchen, Rakelbeschichtung, Vorhanggießverfahren, Aufpinseln, Sprühen oder Reverse-Roll-Beschichtung auf ein Substrat aufgebracht, danach getrocknet, belichtet, mit einer alkalischen Lösung entwickelt und nachfolgend thermisch nachgehärtet wird.

17. Verfahren nach Anspruch 16, **dadurch gekennzeichnet, dass** es sich bei dem Substrat um eine starre oder flexible Leiterplatte handelt.

18. Verfahren nach Anspruch 16 oder 17, **dadurch gekennzeichnet, dass** es sich bei den flexiblen Leiterplatten um unkaschierten oder kupferkaschierten Kunststofffolien auf Basis von Polyester, Polyimid, mit Aramidfasern verstärktes Epoxidharz oder Liquid Crystal Polymer (LCP) handelt.

19. Verfahren nach einem oder mehreren der Ansprüche 16 bis 18, **dadurch gekennzeichnet, dass** die Schichtdicke des Lötstopplackes 0,1 - 50 µm beträgt.

## Claims

1. A flame-retardant resin formulation comprising respectively at least one flame-retardant component, one alkali-soluble component, one polymerizable monomer, one photoinitiator, and one epoxy component, which comprises, as flame-retardant component, a phosphinic salt of the formula (I) 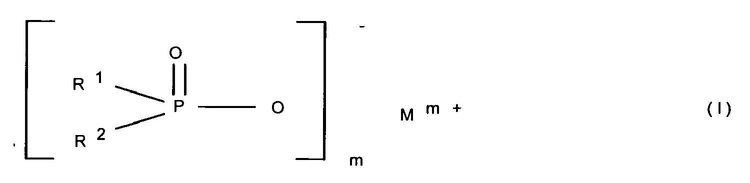 in which
R¹ and R² are identical or different and, independently of one another, are C₁-C₆-alkyl, linear or branched, and/or aryl;
M is Mg, Ca, Al, Sb, Sn, Ge, Ti, Zn, Fe, Zr, Ce, Bi, Sr, Mn, Li, Na, K, and/or a protonated nitrogen base, and m is from 1 to 4.

2. The flame-retardant resin formulation as claimed in claim 1, wherein R¹ and R² are identical or different and are methyl, ethyl, n-propyl, isopropyl, n-butyl, tert-butyl, n-pentyl, and/or phenyl.

3. The flame-retardant resin formulation as claimed in claim 1 or 2, wherein the phosphinic salt of the formula (I) is the aluminum salt of diethylphosphinic acid.

4. The flame-retardant resin formulation for a solder resist as claimed in one or more of claims 1 to 3, wherein the median particle size (d₅₀) of the aluminum salt of diethylphosphinic acid is from 0.1 to 100 µm, preferably from 1 to 20 µm.

5. The flame-retardant resin formulation as claimed in one or more of claims 1 to 4, wherein the alkali-soluble component is a modified epoxy acrylate.

6. The flame-retardant resin formulation as claimed in one or more of claims 1 to 5, wherein the polymerizable monomer is polyfunctional acrylates of polyhydric alcohols.

7. The flame-retardant resin formulation as claimed in claim 6, wherein the polyhydric alcohols are pentaerythritol and/or dipentaerythritol.

8. The flame-retardant resin formulation as claimed in one or more of claims 1 to 7, wherein the photoinitiator is alpha-aminoacetophenones.

9. The flame-retardant resin formulation as claimed in claim 8, wherein the compound here is (4-methylthiobenzoyl)-1-methyl-1-morpholinoethane.

10. The flame-retardant resin formulation as claimed in one or more of claims 1 to 9, wherein the epoxy compound is an epoxidized novolak.

11. The flame-retardant resin formulation as claimed in one or more of claims 1 to 10, which comprises at least
from 0.1 to 50% by weight of flame-retardant component,
from 0.1 to 65% by weight of alkali-soluble component,
from 0.1 to 65% by weight of polymerizable monomer,
from 0.1 to 15% by weight of photoinitiator, and
from 0.1 to 25% by weight of epoxy component.

12. The flame-retardant resin formulation as claimed in one or more of claims 1 to 11, which comprises at least
from 5 to 20% by weight of flame-retardant component,
from 30 to 40% by weight of alkali-soluble component,
from 5 to 10% by weight of polymerizable monomer,
from 4 to 5% by weight of photoinitiator, and
from 5 to 10% by weight of epoxy component.

13. The flame-retardant resin formulation as claimed in one or more of claims 1 to 12, which moreover comprises from 0.1 to 30% by weight, preferably from 1 to 20% by weight, of at least one synergistic flame-retardant component, which is melamine, melamine derivatives of cyanuric acid, melamine derivatives of isocyanuric acid, melamine salts, such as melamine phosphate, melamine polyphosphate, or melamine diphosphate, dicyandiamide, or a guanidine compound , such as guanidine carbonate, guanidine phosphate, guanidine sulfate, and/or condensates of ethyleneurea and formaldehyde, or ammonium polyphosphate; oxygen compounds of silicon, these being orthosalicic acid and its condensates, or being silicates, zeolites, and silicas; or aluminum hydroxide.

14. The use of the flame-retardant resin formulation as claimed in one or more of claims 1 to 13 in, or for the production of, coatings for electronics and electrical engineering.

15. The use of the flame-retardant resin formulation as claimed in one or more of claims 1 to 14 as a solder resist.

16. The process for the production of flame-retardant solder resists as claimed in claim 15, which comprises using spincoating, dip coating, doctor coating, curtain coating, brushing, spraying, or reverse roll coating to apply a thin layer of the solder resist to a substrate, and then drying and exposing the layer to light, developing it with an alkaline solution, and then thermally post-curing it.

17. The process as claimed in claim 16, wherein the substrate is a rigid or flexible printed circuit board.

18. The process as claimed in claim 16 or 17, wherein the flexible printed circuit boards are uncoated or copper-coated plastics polymers based on polyester, polyimide, epoxy resin reinforced with aramide fibers, or Liquid Crystal Polymer (LCP).

19. The process as claimed in one or more of claims 16 to 18, wherein the layer thickness of the solder resist is from 0.1 to 50 µm.

## Revendications

1. Formulation de résine ignifuge, contenant à chaque fois au moins un composant retardateur de flamme, un composant soluble dans les alcalis, un monomère polymérisable, un photo-initiateur et un composant époxy, **caractérisée en ce qu'**elle contient, comme composant retardateur de flamme, un sel d'acide phosphinique de formule (I), 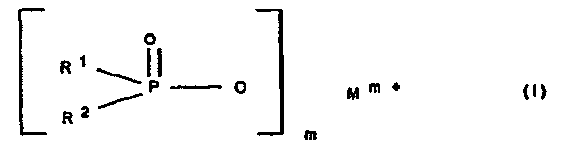 où
R¹, R² sont identiques ou différents et représentent, indépendamment l'un de l'autre, C₁-C₆-alkyle linéaire ou ramifié et/ou aryle ;
M signifient Mg, Ca, Al, Sb, Sn, Ge, Ti, Zn, Fe, Zr, Ce, Bi, Sr, Mn, Li, Na, K et/ou une base azotée protonée et m vaut 1 à 4.

2. Formulation de résine ignifuge selon la revendication 1, **caractérisée en ce que** R¹, R² sont identiques ou différents et signifient méthyle, éthyle, n-propyle, iso-propyle, n-butyle, tert-butyle, n-pentyle et/ou phényle.

3. Formulation de résine ignifuge selon la revendication 1 ou 2, **caractérisée en ce qu'**il s'agit, pour le sel d'acide phosphinique de formule (I), du sel d'aluminium de l'acide diéthylphosphinique.

4. Formulation de résine ignifuge pour un masquage pour la soudure selon l'une ou plusieurs des revendications 1 à 3, **caractérisée en ce que** le sel d'aluminium de l'acide diéthylphosphinique présente une grosseur moyenne des particules (d₅₀) de 0,1 à 100 µm, de préférence de 1 à 20 µm.

5. Formulation de résine ignifuge selon l'une ou plusieurs des revendications 1 à 4, **caractérisée en ce qu'**il s'agit, pour le composant soluble dans les alcalis, d'un époxyacrylate modifié.

6. Formulation de résine ignifuge selon l'une ou plusieurs des revendications 1 à 5, **caractérisée en ce qu'**il s'agit, pour les monomères polymérisables, d'acrylates polyvalents d'alcools polyvalents.

7. Formulation de résine ignifuge selon la revendication 6, **caractérisée en ce qu'**il s'agit, pour les alcools polyvalents, de pentaérythritol et/ou dipentaérythritol.

8. Formulation de résine ignifuge selon l'une ou plusieurs des revendications 1 à 7, **caractérisée en ce qu'**il s'agit, pour le photo-initiateur, d'alpha-aminoacétophénone.

9. Formulation de résine ignifuge selon la revendication 8, **caractérisée en ce qu'**il s'agit de (4-méthylthiobenzoyl)-1-méthyl-1-morpholinoéthane.

10. Formulation de résine ignifuge selon l'une ou plusieurs des revendications 1 à 9, **caractérisée en ce qu'**il s'agit, pour le composé époxy, d'une novolaque époxydée.

11. Formulation de résine ignifuge selon l'une ou plusieurs des revendications 1 à 10, **caractérisée en ce que** la formulation de résine ignifuge contient au moins
| | |
|---|---|
| 0,1-50% en poids | de composant retardateur de flammes, |
| 0,1-65% en poids | de composant soluble dans les alcalis, |
| 0,1-65% en poids | de monomère polymérisable, |
| 0,1-15% en poids | de photo-initiateur et |
| 0,1-25% en poids | de composant époxy. |

12. Formulation de résine ignifuge selon l'une ou plusieurs des revendications 1 à 11, **caractérisée en ce que** la formulation de résine ignifuge contient au moins
| | |
|---|---|
| 5-20% en poids | de composant retardateur de flammes, |
| 30-40% en poids | de composant soluble dans les alcalis, |
| 5-10% en poids | de monomère polymérisable, |
| 4-5% en poids | de photo-initiateur et |
| 5-10% en poids | de composant époxy. |

13. Formulation de résine ignifuge selon l'une ou plusieurs des revendications 1 à 12, **caractérisée en ce que** la formulation de résine ignifuge contient en outre 0,1 à 30% en poids, de préférence 1 à 20% en poids d'au moins un composant retardateur de flamme synergique, pour lequel il s'agit de mélamine, de dérivés de mélamine de l'acide cyanurique, de dérivés de mélamine de l'acide isocyanurique, de sels de mélamine, tels que le phosphate de mélamine, le polyphosphate de mélamine ou le diphosphate de mélamine, du dicyanodiamide ou d'un composé de guanidine, tel que le guanidine-carbonate, le guanidine-phosphate, le guanidine-sulfate et/ou de produits de condensation d'éthylène-urée et de formaldéhyde ou de polyphosphate d'ammonium ; de composés oxygénés du silicium, où il s'agit d'acide orthosilique et de ses produits de condensation, de silicates, de zéolithes et de silices ; ou d'hydroxyde d'aluminium.

14. Utilisation de la formulation de résine ignifuge selon l'une ou plusieurs des revendications 1 à 13 dans ou pour la préparation de revêtements pour l'électronique et l'électrotechnique.

15. Utilisation de la formulation de résine ignifuge selon l'une ou plusieurs des revendications 1 à 14 comme masquage pour la soudure.

16. Procédé pour la préparation de masquages pour la soudure retardateurs de flamme selon la revendication 15, **caractérisé en ce qu'**on applique sur un substrat une couche mince du masquage pour la soudure par centrifugation, immersion, revêtement à la racle, des procédés à rideau, enduction, pulvérisation ou revêtement par rouleau inverse, puis on sèche, on éclaire, on développe avec une solution alcaline, puis on post-durcit thermiquement.

17. Procédé selon la revendication 16, **caractérisé en ce qu'**il s'agit, pour le substrat, d'un circuit imprimé rigide ou souple.

18. Procédé selon la revendication 16 ou 17, **caractérisé en ce qu'**il s'agit, pour les circuits imprimés souples, de feuilles non contrecollées ou contrecollées par du cuivre, à base de polyester, de polyimide, de résine époxyde renforcée par des fibres de verre ou d'un polymère à cristaux liquides (LCP).

19. Procédé selon l'une ou plusieurs des revendications 16 à 18, **caractérisé en ce que** l'épaisseur de couche du masquage pour soudure est de 0,1-50 µm.
